(19) Europäisches Patentamt / European Patent Office / Office européen des brevets

(11) **EP 1 299 911 B1**

(12) **EUROPÄISCHE PATENTSCHRIFT**

(45) Veröffentlichungstag und Bekanntmachung des Hinweises auf die Patenterteilung:
**03.06.2009 Patentblatt 2009/23**

(51) Int Cl.:
***H01L 33/00*** *(2006.01)*

(21) Anmeldenummer: **01953901.4**

(22) Anmeldetag: **10.07.2001**

(86) Internationale Anmeldenummer:
**PCT/DE2001/002566**

(87) Internationale Veröffentlichungsnummer:
**WO 2002/005358 (17.01.2002 Gazette 2002/03)**

(54) **STRAHLUNGSEMITTIERENDER HALBLEITERCHIP**

RADIATION-EMITTING SEMICONDUCTOR CHIP

PUCE A SEMI-CONDUCTEUR A EMISSION DE RAYONNEMENT

(84) Benannte Vertragsstaaten:
**DE FR GB**

(30) Priorität: **10.07.2000 DE 10033496**

(43) Veröffentlichungstag der Anmeldung:
**09.04.2003 Patentblatt 2003/15**

(73) Patentinhaber: **OSRAM Opto Semiconductors GmbH**
**93055 Regensburg (DE)**

(72) Erfinder:
• **EISERT, Dominik**
**93049 Regensburg (DE)**
• **HÄRLE, Volker**
**93164 Waldetzenberg (DE)**
• **STRAUSS, Uwe**
**93077 Bad Abbach (DE)**
• **ZEHNDER, Ulrich**
**93049 Regensburg (DE)**

(74) Vertreter: **Epping - Hermann - Fischer**
**Patentanwaltsgesellschaft mbH**
**Ridlerstrasse 55**
**80339 München (DE)**

(56) Entgegenhaltungen:
WO-A-99/31738          DE-A- 4 427 840
US-A- 5 260 588        US-A- 5 753 940

• PATENT ABSTRACTS OF JAPAN vol. 007, no. 243 (E-207), 28. Oktober 1983 (1983-10-28) & JP 58 131782 A (SUMITOMO DENKI KOGYO), 5. August 1983 (1983-08-05)
• PATENT ABSTRACTS OF JAPAN vol. 005, no. 113 (E-066), 22. Juli 1981 (1981-07-22) & JP 56 050586 A (MITSUBISHI ELECTRIC CO), 7. Mai 1981 (1981-05-07)
• PATENT ABSTRACTS OF JAPAN vol. 1995, no. 08, 29. September 1995 (1995-09-29) & JP 07 131066 A (NEC CO), 19. Mai 1995 (1995-05-19)
• PATENT ABSTRACTS OF JAPAN vol. 010, no. 313 (E-448), 24. Oktober 1986 (1986-10-24) & JP 61 125092 A (NEC CO), 12. Juni 1986 (1986-06-12)
• PATENT ABSTRACTS OF JAPAN vol. 1996, no. 12, 26. Dezember 1996 (1996-12-26) & JP 08 222763 A (SHARP CORP), 30. August 1996 (1996-08-30)
• PATENT ABSTRACTS OF JAPAN vol. 018, no. 406 (E-1585), 28. Juli 1994 (1994-07-28) -& JP 06 120560 A (VICTOR CO OF JAPAN), 28. April 1994 (1994-04-28)

EP 1 299 911 B1

**Beschreibung**

Die Erfindung betrifft einen strahlungsemittierenden Halbleiterchip mit einer strahlungsemittierenden aktiven Schicht.

Ein derartiger Halbleiterchip ist aus der DE 198 07 758 A1 bekannt. Der bekannte Halbleiterchip weist eine auf einem Substrat aufgebrachte Heterostruktur auf, die eine Vielzahl von dotierten Epitaxieschichten vom p- und n-Typ aufweist. Entlang der Grenzfläche zwischen den Epitaxieschichten vom p- und vom n-Typ ist eine aktive Schicht ausgebildet, in der Photonen generiert werden.

Um die Lichtauskopplung des bekannten Halbleiterchips zu verbessern, ist der bekannte Halbleiterchip pyramidenstumpfförmig ausgebildet. Durch die abgeschrägten Seitenflächen ist sichergestellt, daß das von der aktiven Schicht erzeugte Licht nach wenigen Reflexionen an den Seitenflächen den Halbleiterchip verlassen kann.

Ein Nachteil des bekannten Halbleiterchips ist, daß die Lichtausbeute nicht dem entspricht, was aufgrund der geometrischen Verhältnisse und der Brechungsindizes eigentlich zu erwarten wäre. Dies liegt hauptsächlich an den Absorptionsverlusten beim Durchgang der Lichtstrahlen durch das Material und bei der Reflexion an den Seitenflächen.

Ein Halbleiterchip gemäß dem Oberbegriff des Anspruchs 1 ist zum Beispiel aus WO-A-9 993 1738 oder US-A-5 260 588 bekannt.

Ausgehend von diesem Stand der Technik liegt der Erfindung die Aufgabe zugrunde, einen Halbleiterchip mit verbesserter Lichtauskopplung zu schaffen.

Diese Aufgabe wird erfindungsgemäß mit einem Halbleiterchip nach dem Anspruch 1 gelöst.

Durch die Unterteilung der aktiven Schicht in eine Vielzahl von Teilbereichen wird die Gesamtfläche der Seitenflächen vergrößert. Außerdem erscheint von jedem Leuchtpunkt der aktiven Schicht aus gesehen die jeweils nächstliegende Seitenfläche unter einem größerem Raumwinkel. Ein Großteil der vom Leuchtpunkt der aktiven Schicht ausgehenden Lichtstrahlen trifft daher unmittelbar auf eine Seitenfläche und kann dort aus dem Halbleiterchip austreten.

Durch die Unterteilung der aktiven Schicht in eine Vielzahl von Teilbereichen geht zwar ein Bruchteil der aktiven Schicht über für die Lichterzeugung verloren, aber dafür wird die Lichtauskopplung wesentlich verbessert. Insgesamt wird daher durch die vorgeschlagenen Maßnahmen die Effizienz bei der Lichterzeugung verbessert.

Weitere vorteilhafte Ausgestaltungen sind Gegenstand der abhängigen Ansprüche.

Nachfolgend werden Ausführungsbeispiele der Erfindung anhand der beigefügten Zeichnung erläutert. Es zeigen:

Figur 1a und b den Verlauf von Lichtstrahlen in aktiven Schichten, von herkömmlichen Halbleiterchips;

Figur 1c und d den Verlauf von Lichtstrahlen in Halbleiterchips nicht gemäß der Erfindung;

Figur 2 einen Querschnitt eines abgewandelten Ausführungsbeispiels des Halbleiterchips, bei dem die Ausnehmungen in der aktiven Schicht abgeschrägte Seitenflächen aufweisen;

Figur 3 einen Querschnitt durch ein weiteres abgewandeltes Beispiel nicht gemäß der Erfindung, bei dem die Ausnehmungen in der aktiven Schicht hinterschnitten sind;

Figur 4 einen Querschnitt durch ein Beispiel eines Halbleiterchips nicht gemäß der Erfindung, bei dem die aktive Schicht aus einer Vielzahl von gegeneinander verkippten, flachen Abschnitten zusammengesetzt ist;

Figur 5 einen Querschnitt durch ein weiteres abgewandeltes Ausführungsbeispiel, bei dem die Ausnehmungen in der aktiven Schicht hinterschnitten sind; und

Figur 6 bis 8 Aufsichten auf jeweils einen Halbleiterchip gemäß der Erfindung.

In Figur la ist ein herkömmlicher optoelektronischer Halbleiterchip 1 dargestellt, der über ein Substrat 2 mit einer Hauptfläche , auf dem eine aktive Schicht 3 aufgebracht ist.

Auf der aktiven Schicht 3 sind Kontaktstellen 4 angebracht. Diese Kontaktstellen 4 tragen auch zu den Verlusten im Halbleiterchip 1 bei. Beispielsweise wird ein Lichtstrahl 5, der von einem Licht erzeugenden Punkt 6 innerhalb der aktiven Schicht 3 ausgeht, zunächst an einer Unterseite 7 und dann an einer Oberseite 8 reflektiert. Dabei trifft der Lichtstrahl 5 auf die Unterseite der Kontaktstelle 4 und wird dort teilweise absorbiert. Das gleiche für die weiteren Reflexionen an der Unterseite 7 und der Oberseite 8. Bei jeder Reflexion geht ein Teil der Intensität des Lichtstrahls 5 verloren. Außerdem ist auch der Durchgang durch das Material der aktiven Schicht 3 mit Verlusten behaftet. Der Lichtstrahl 5 wird daher stark geschwächt aus einer Seitenfläche 9 der aktiven Schicht 3 austreten.

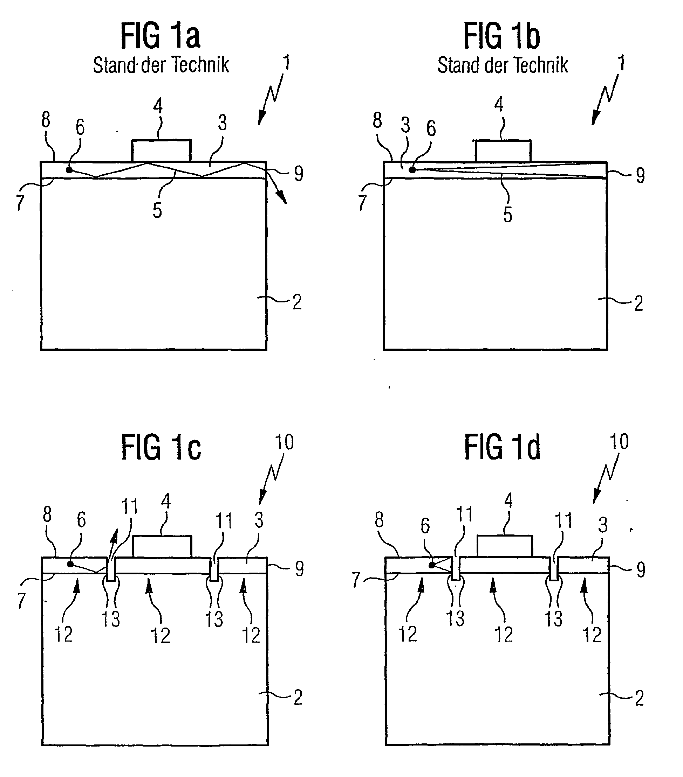

Hinzu kommt, daß nur ein kleiner Raumwinkelanteil des vom Licht erzeugenden Punkt 6 ausgehenden Lichts unmittelbar auf die Seitenfläche 9 trifft. Dies wird anhand von Figur 1b deutlich. Diejenigen Lichtstrahlen, die außerhalb des Raumwinkelbereichs liegen, in dem die Seitenflächen 9 vom Licht erzeugenden Punkt 6 aus gesehen erscheinen, werden mehr oder weniger häufig an der Unterseite 7 und der Oberseite 8 der aktiven Schicht 3 reflektiert und in ihrer Intensität geschwächt.

Um die Lichtauskopplung zu verbessern, sind bei dem in den Figuren 1c und 1d dargestellten Halbleiterchip 10 Ausnehmungen 11 in die aktive Schicht 3 eingebracht, durch die die aktive Schicht 3 in Teilbereiche 12 unterteilt wird.

Die Bezeichnung aktive Schicht steht bei der Erfindung für diejenigen Schichten des Halbleiterchips 1, die zur Lichterzeugung beitragen. Dazu zählt nicht nur diejenige Zone, in der Licht generiert wird, sondern dazu zählen auch die angrenzenden stromtragenden Schichten. Weitergehend kann auf das Substrat (2) eine Schichtenfolge aufgebracht sein, die die aktive Schicht (3) enthält. Weitere Schichten der Schichtenfolge können beispielsweise der Kontaktierung der aktiven Schicht, der Gitteranpassung, der Stromführung oder einer Führung des Lichtfeldes dienen.

Der Einfachheit halber ist in den Figuren der Zeichnung auf dem Substrat nur eine Schicht 3 dargestellt, die im folgenden kurz als aktive Schicht bezeichnet wird. Hierunter ist auch eine die aktive Schicht umfassende Schichtenfolge zu verstehen, die in den Figuren zu der Schicht 3 zusammengefaßt ist.

Es sei weiterhin angemerkt, daß bei der Erfindung mit dem Begriff Lichtstrahlen nicht nur Strahlen mit Wellenlängen im sichtbaren Wellenlängenbereich gemeint sind. Vielmehr gelten die hier vorgestellten Überlegungen grundsätzlich für jede Art von elektromagnetischer Strahlung, insbesondere für Licht im gesamten Spektralbereich vom Infraroten bis zum Ultravioletten. Der im Rahmen der geometrischen Optik verwendete Begriff des Lichtstrahls soll daher nicht eine bestimmte Wellenlänge der elektromagnetischen Strahlung implizieren.

Die Teilbereiche der aktiven Schicht 3 können beispielsweise in der Aufsicht auf die aktive Schicht kachelartig angeordnet sein. Hierunter ist eine in der Ebene der aktiven Schicht flächige Anordnung nach einem sich wiederholenden Muster zu verstehen.

Als Material für die Schichtenfolge und insbesondere für die aktive Schicht 3 eignen sich bei derErfindung vorzugsweise GaN-basierende Halbleitermaterialien wie beispielsweise GaN, AlGaN, InGaN oder AlInGaN. Derartige Schichtenfolgen können epitaktisch hergestellt werden, wobei als Epitaxiesubstrat SiC-Substrate, Saphirsubstrate oder Si-Substrate sowie daraus gebildete Verbundsubstrate bervorzugt verwendet werden.

Durch die Unterteilung der aktiven Schicht 3 in eine Mehrzahl von Teilbereichen ist gewährleistet, daß der vom Licht erzeugenden Punkt 6 ausgehende Lichtstrahl 5 nach wenigen Reflexionen auf eine der Seitenflächen 13 der Ausnehmungen 11 trifft. Aufgrund der geringen flächenmäßigen Ausdehnung der Teilbereiche 12 erscheinen die Seitenflächen 13 vom Licht erzeugenden Punkt 6 aus gesehen unter großen Raumwinkeln. Dies bedeutet, daß ein entsprechend großer Anteil der vom Licht erzeugenden Punkt 6 ausgehenden Lichtstrahlen unmittelbar auf die Seitenflächen 13 trifft und dort nach außen transmittiert wird. Letzteres ist insbesondere anhand von Figur 1d deutlich erkennbar.

Das in den Ausnehmungen 11 austretende Licht soll nach Möglichkeit nicht an den gegenüberliegenden Seitenflächen 13 wieder in die aktive Schicht 3 einkoppeln. Dieses Ziel läßt sich durch eine besondere Formgebung der Seitenflächen 13 der Ausnehmungen 11 erreichen.

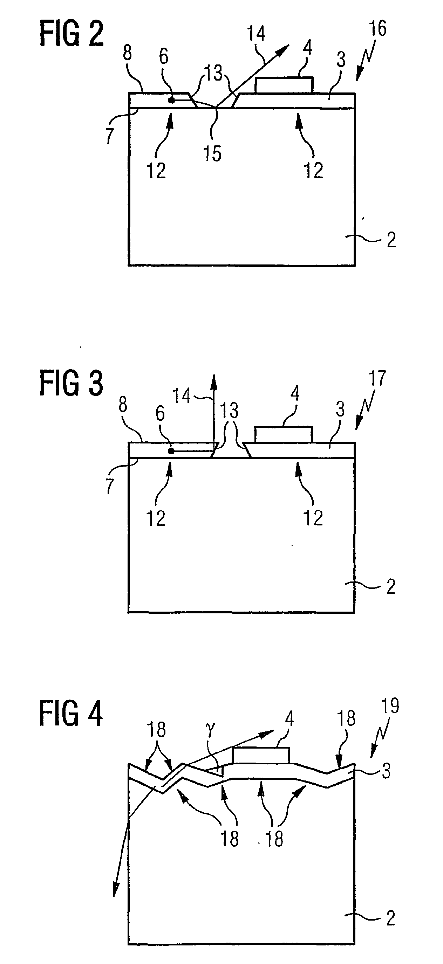

Beispielsweise ist es möglich, wie in Figur 2 dargestellt, die Seitenflächen 13 abzuschrägen. Ein in einer Haupterstrekkungsrichtung der aktiven Schicht 3 propagierender, d.h. im wesentlichen parallel zu einer durch die aktive Schicht 3 festgelegten Schichtebene verlaufender Lichtstrahl 14, im folgenden als zentraler Lichtstrahl 14 bezeichnet, wird dann beim Durchtritt durch die Seitenflächen 13 in Richtung zu einem Boden 15 der Ausnehmung 11 reflektiert. Am Boden 15 trifft der zentrale Lichtstrahl 14 auf das Substrat 2 und wird dort reflektiert. Falls die Ausnehmung 11 ausreichend breit ist, wird der Lichtstrahl 14 ausgekoppelt. Dies bedeutet insbesondere, daß der Lichtstrahl 14 den Halbleiterchip verläßt, ohne nochmals in die Schichtenfolge einzutreten oder auf die aktive Schicht 3 zu treffen.

Bei dem in Figur 2 dargestellten Halbleiterchip 16 besteht daher nicht die Gefahr, daß die aus der aktiven Schicht 3 austretenden Lichtstrahlen wieder in die aktive Schicht 3 eingekoppelt werden.

Eine weitere Möglichkeit ist in Figur 3 dargestellt. Bei dem in Figur 3 dargestellten Halbleiterchip 17 verjüngt sich die Ausnehmung von dem Substrat aus in Richtung der dem Substrat gegenüberliegenden Seite der aktiven Schicht. Die Ausnehmung 11 ist dabei so stark hinterschnitten, daß der zentrale Lichtstrahl 14 an der Seitenfläche 13 totalreflektiert wird. Die Neigung der Seitenfläche ist insbesondere so gewählt, daß der zentrale Lichtstrahl 14 an der Seitenfläche 13 unter einem großen Winkel, insbesondere einem rechtem Winkel, auf die Oberseite 8 trifft und dort transmittiert wird.

Schließlich besteht die Möglichkeit, die aktive Schicht 3 aus gegeneinander verkippten, flachen Teilbereichen 18 zusammenzusetzen. Bei dieser Anordnung der aktiven Schicht 3 sind die Seitenflächen eines Teilbereichs 18 von der Oberseite 8 oder Unterseite 7 eines der benachbarten Teilbereiche 18 gebildet. Damit an der Oberseite 8 oder der Unterseite 7 keine Totalreflexion stattfindet, muß der Kippwinkel $\gamma$ größer als der kritische Winkel für die Totalreflexion sein, wobei der kritische Winkel für die Totalreflexion durch $\sin \alpha_C = n_2/n_1$ definiert ist. $n_2$ ist dabei die Brechzahl in dem an die aktive Schicht 3 angrenzenden Medium und $n_1$ die Brechzahl in der aktiven Schicht 3.

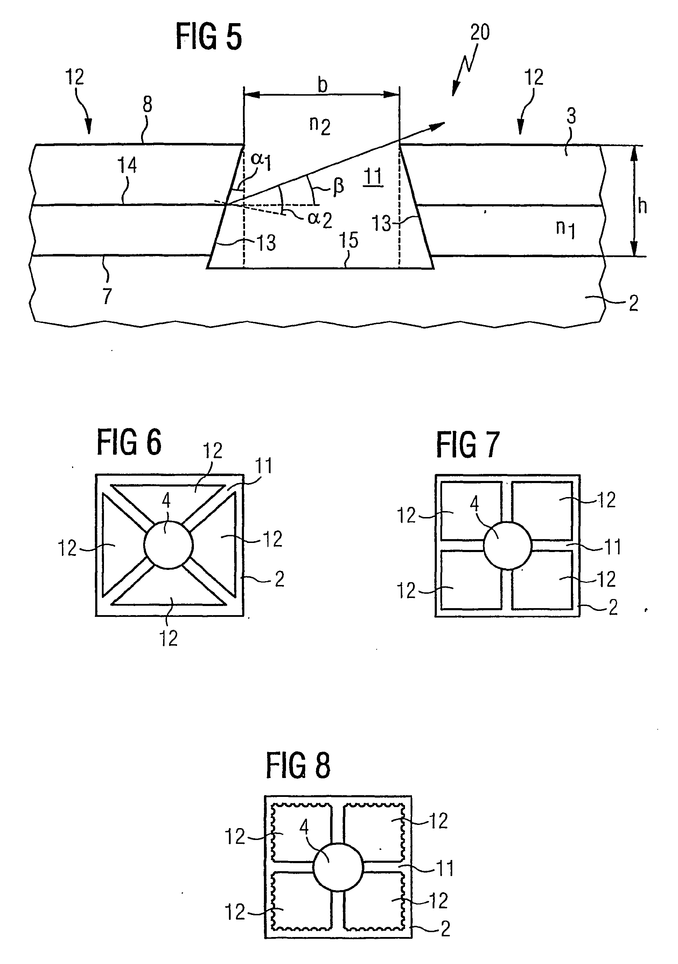

In Figur 5 ist schließlich der Fall dargestellt, daß die Ausnehmungen 11 wie in Figur 3 hinterschnitten sind. In diesem Fall liegt der Flankenwinkel $\alpha_1$ der Ausnehmung 11 zwischen 0° und dem kritischen Winkel für die Totalreflexion $\alpha_C$. Daher wird in diesem Fall der zentrale Lichtstrahl 14 in Richtung der Oberseite 8 gebrochen. Um zu verhindern, daß der zentrale Lichtstrahl 14 auf die gegenüberliegende Seitenflächen 13 auftrifft, muß die Breite der Ausnehmungen 11 ausreichend breit gewählt werden. Anhand Figur 5 läßt sich leicht die Bedingung dafür ablesen. Für die Breite b der Ausnehmung 11 muß gelten:

$$b \geq \frac{h}{2 \tan(\alpha_2 - \alpha_1)}$$

mit:

$$\sin \alpha_1 = \frac{n_1}{n_2} \sin \alpha_2$$

wobei h die Dicke der aktiven Schicht 3 ist, $\alpha_1$ und $\alpha_2$ jeweils die Winkel zwischen der Flächennormale der Seitenfläche 13 und dem einfallenden Lichtstrahl 14 und dem transmittierten Lichtstrahl 14 sind und $n_1$ und $n_2$ die Brechungindizes in der aktiven Schicht 13 und in der Ausnehmung 11. Damit wird erreicht, daß der Lichtstrahl an der Seitenfläche der Ausnehmung gebrochen wird und unmittelbar danach den Halbleiterchip verläßt. Dies bedeutet insbesondere, daß der Lichtstrahl nicht erneut in die Schichtenfolge eintritt.

Für die flächenmäßige Ausgestaltung der Ausnehmungen 11 kommen verschiedene Formen in Frage. In den Figuren 6 und 7 sind zwei Möglichkeiten dargestellt. In Figur 6 sind die Ausnehmungen 11 in der Art eines Kreuzes , in Fig. 7 in der Art eines Andreaskreuzes gebildet.

Die hier beschriebenen Maßnahmen lassen sich auch mit weiteren Maßnahmen zur Verbesserung der Lichtauskopplung kombinieren. Beispielsweise können die Seitenflächen 9 sowie die Oberseite 8 durch eine geeignete Behandlung aufgerauht werden. Ferner ist es möglich, in den Seitenflächen 3 und der Oberseite 8 Rillen oder ähnliche Unebenheiten zur Verbesserung der Lichtauskopplung vorzusehen. Ein derartiges Ausführungsbeispiel ist in Figur 8 dargestellt, bei dem die aktive Schicht in Aufsicht briefmarkenförmig ausgebildet ist.

**Patentansprüche**

1.  Strahlungsemittierender Halbleiterchip mit einem Substrat (2) mit einer Hauptfläche,
    und einer eine strahlungsemittierende aktive Schicht (3) umfassende Schichtenfolge, die auf der Hauptfläche des Substrats (2) angeordnet ist, wobei
    die aktive Schicht (3) durch Ausnehmungen (11) in eine Mehrzahl von Teilbereichen (12, 18) mit quer zur aktiven Schicht (3) verlaufenden Seitenflächen (7, 8, 13) unterteilt ist, **dadurch gekennzeichnet, daß**

- zumindest eine der Ausnehmungen (11) eine Seitenfläche (13) aufweist, die in einem vorgegeben, von 90° verschiedenen Winkel zu der Hauptfläche des Substrats (2) angeordnet ist, wobei die Ausnehmung (11) eine Bodenfläche (15) aufweist, und der Abstand zwischen den Seitenflächen (13) der Ausnehmung (11) so gewählt ist, daß zumindest ein Teil der in der aktiven Schicht (3) erzeugten Strahlung an der Bodenfläche (15) der Ausnehmung (11) reflektiert wird und nachfolgend aus dem Halbleiterchip ausgekoppelt wird; oder
- von der Hauptfläche aus gesehen sich zumindest eine der Ausnehmungen in Richtung der der Hauptfläche abgewandten Seite der Schichtenfolge verjüngt, und die Seitenflächen (13) der Ausnehmung einen sich parallel zu einer Haupterstreckungsrichtung der aktiven Schicht (3) ausbreitenden Strahlungsanteil transmittieren und brechen, wobei der Abstand zwischen den seitenflächen der Ausnehmung so gewält ist, daß der Strahlungsanteil nach Brechung an einer seitenfläche den Halbleiterchip unmittelbar verläßt.

2.  Halbleiterchip nach Anspruch 1,
    **dadurch gekennzeichnet, daß**
    von der der Hauptfläche gegenüberliegenden Seite der Schichtenfolge in Richtung des Substrats (2) gesehen sich zumindest eine der Ausnehmungen (11) verjüngt, wenn die zumindest eine der Ausnehmungen (11) die Seitenfläche (13) aufweist, die in dem vorgegeben, von 90° verschiedenen Winkel zu der Hauptfläche des Substrats (2) angeordnet ist, wobei die Ausnehmung die Bodenfläche (15) aufweist, und der Abstand zwischen den Seitenflächen (13) der Ausnehmung (11) so gewählt ist, daß zumindest ein Teil der in der aktiven Schicht (3) erzeugten Strahlung an der Bodenfläche (15) der Ausnehmung (11) reflektiert wird und nachfolgend aus dem Halbleiterchip ausgekoppelt wird.

3.  Halbleiterchip nach Anspruch 1 oder 2,
    **dadurch gekennzeichnet, daß**
    ein sich parallel zu einer Haupterstreckungsrichtung der aktiven Schicht (2) ausbreitender Strahlungsanteil an der Bodenfläche (15) reflektiert wird.

4.  Halbleiterchip nach einem der Ansprüche 1 bis 3, **dadurch gekennzeichnet, daß** die Ausnehmungen (11) die aktive Schicht (3) vollständig unterbrechen.

5.  Halbleiterchip nach einem der Ansprüche 1 bis 4, **dadurch gekennzeichnet, daß**

die Ausnehmungen (11) sich von der dem Substrat (2) abgewandten Seite der Schichtenfolge bis zu der Hauptfläche des Substrats (2) oder in das Substrat (2) erstrekken.

6. Halbleiterchip nach einem der Ansprüche 1 bis 5,
   **dadurch gekennzeichnet, daß**
   die aktive Schicht (3) kachelartig unterteilt ist.

7. Halbleiterchip nach einem der Ansprüche 1 bis 6,
   **dadurch gekennzeichnet, daß**
   das Substrat (2) Silizium, Siliziumoxid, Siliziumcarbid oder Saphir enthält.

8. Halbleiterchip nach einem der Ansprüche 1 bis 7,
   **dadurch gekennzeichnet, daß**
   die Schichtenfolge GaN, AlGaN, InGaN oder AlInGaN enthält.

9. Halbleiterchip nach Anspruch 8,
   **dadurch gekennzeichnet, daß**
   die aktive Schicht (3) GaN, AlGaN, InGaN oder AlInGaN enthält.

10. Halbleiterchip nach einem der Ansprüche 1 bis 9,
    **dadurch gekennzeichnet, daß**
    die Schichtenfolge epitaktisch auf das Substrat (3) aufgebracht ist.

**Claims**

1. Radiation emitting semiconductor chip having a substrate (2) with a main surface, and a series of layers comprising a radiation emitting active layer (3), which is arranged on the main surface of the substrate (2), wherein the active layer (3) is divided by recesses (11) into a number of subregions (12, 18) with lateral surfaces (7, 8, 13) extending transversely relative to the active layer (3), **characterised in that**

   - at least one of the recesses (11) has a lateral surface (13) arranged at a predefined angle different to 90° to the main surface of the substrate (2), wherein the recess (11) has a base surface (15), and the distance between the lateral surfaces (13) of the recess (11) is selected such that at least some of the radiation generated in the active layer (3) is reflected at the base surface (15) of the recess (11) and is subsequently coupled out of the semiconducting chip; or
   - at least one of the recesses narrows in the direction of the side of the layer sequence facing away from the main surface when viewed from the main surface, and the lateral surfaces (13) of the recess transmit and refract a radiation component propagating parallel to a main extension direction of the active layer (3), wherein the distance between the lateral surfaces of the recess is selected such that the radiation component after refraction at a lateral surface directly exits the semiconductor chip.

2. Semiconducting chip according to Claim 1,
   **characterised in that** at least one of the recesses (11) narrows in the direction of the substrate (2), when viewed from the side of the layer sequence opposite the main surface, if the at least one of the recesses (11) has the lateral surface (13) that is arranged at the predefined angle different to 90° to the main surface of the substrate (2), whereby the recess has the base surface (15), and the distance between the lateral surfaces (13) of the recess (11) is selected such that at least a part of the radiation generated in the active layer (3) is reflected at the base surface (15) of the recess (11) and is subsequently coupled out of the semiconducting chip.

3. Semiconducting chip according to Claim 1 or 2,
   **characterised in that** a radiation component propagating parallel to a major extension direction of the active layer (2) is reflected at the base surface (15).

4. Semiconducting chip according to any one of Claims 1 to 3,
   **characterised in that** the recesses fully interrupt the active layer (2).

5. Semiconducting chip according to any one of Claims 1 to 4,
   **characterised in that** the recesses (11) extend from the side of the layer sequence facing away from the substrate (2) to the main surface of the substrate (2) or into the substrate (2).

6. Semiconducting chip according to any one of Claims 1 to 5,
   **characterised in that** the active layer (3) is divided in a tiled manner.

7. Semiconducting chip according to any one of Claims 1 to 6,
   **characterised in that** the substrate (2) contains silicon, silicon oxide, silicon carbide or sapphire.

8. Semiconducting chip according to any one of Claims 1 to 7,
   **characterised in that** the layer sequence contains GaN, AlGaN, InGaN or AlInGaN.

9. Semiconducting chip according to Claim 8,
   **characterised in that** the active layer (1) contains GaN, AlGaN, InGaN or AlInGaN.

10. Radiation emitting semiconducting chip according to any one of Claims 1 to 9,

**characterised in that** the layer sequence is epitaxially applied to the substrate (3).

**Revendications**

1. Puce semiconductrice émettant un rayonnement avec un substrat (2) avec une surface principale et une série de couches enveloppant une couche active (3) émettant un rayonnement, laquelle série de couches est agencée sur la surface principale du substrat (2), sachant que la couche active (3) est subdivisée par des creux (11) en une multitude de sections partielles (12, 18) avec des surfaces latérales (7, 8, 13) s'étendant en travers à la couche active (3), **caractérisée en ce que**

   ■ au moins l'un des creux (11) comporte une surface latérale (13), qui est disposée à un angle prédéterminé, différent de 90°, par rapport à la surface principale du substrat (2), sachant que le creux (11) comporte une surface de fond (15) et que l'écart entre les surfaces latérales (13) du creux (11) est choisi de manière à ce qu'au moins une part du rayonnement généré dans la couche active (3) soit réfléchie à la surface de fond (15) du creux (11) puis découplé de la puce semiconductrice ;
   ou
   ■ vue de la surface principale, au moins l'un des creux (11) s'amincit vers la face de la série couches qui es détournée de la surface principale et que les surfaces latérales (13) du creux transmettent et réfractent une part de rayonnement se propageant parallèlement à un sens d'extension principal de la couche active (3), sachant que l'écart entre les surfaces latérales du creux (11) est choisi de manière à ce que la part de rayonnement sorte de la puce semiconductrice à une surface latérale immédiatement après la réfraction.

2. Puce semiconductrice selon la revendication 1, **caractérisée en que,** vu de la face de la série de couches opposée à la surface principale, au moins l'un des creux (11) s'amincit vers le substrat (2) lorsque l'au moins des creux (11) comporte la surface latérale (13), qui est disposée à un angle prédéterminé, différent de 90°, par rapport à la surface principale du substrat (2), sachant que le creux comporte la surface de fond (15) et que l'écart entre les surfaces latérales (13) du creux (11) est choisi de manière à ce qu'au moins une part du rayonnement généré dans la couche active (3) soit réfléchie à la surface de fond (15) du creux (11) puis découplé de la puce semiconductrice.

3. Puce semiconductrice selon la revendication 1 ou 2, **caractérisée en ce qu'**une part de rayonnement se propageant parallèlement à un sens d'extension principal de la couche active (2) est réfléchie à la surface de fond.

4. Puce semiconductrice selon l'une quelconque des revendications 1 à 3, **caractérisée en ce que** les creux (11) interrompent totalement la couche active (3).

5. Puce semiconductrice selon l'une quelconque des revendications 1 à 4, **caractérisée en ce que** les creux (11) s'étendent de la face de la série de couches détournée du substrat (2) jusqu'à la surface principale du substrat (2) ou jusque dans le substrat (2).

6. Puce semiconductrice selon l'une quelconque des revendications 1 à 5, **caractérisée en ce que** la couche active (3) est subdivisée à la manière d'un carreau.

7. Puce semiconductrice selon l'une quelconque des revendications 1 à 6, **caractérisée en ce que** le substrat (2) contient du silicium, de l'oxyde de silicium, du carbure de silicium ou du saphir.

8. Puce semiconductrice selon l'une quelconque des revendications 1 à 6, **caractérisée en ce que** la série de couches contient du GaN, du AlGaN, du InGaN ou du AlInGaN.

9. Puce semiconductrice selon la revendication 8, **caractérisée en ce que** la couche active (3) contient du GaN, du AlGaN, du InGaN ou du AlInGaN.

10. Puce semiconductrice selon l'une quelconque des revendications 1 ou 9, **caractérisée en ce que** la série de couches est appliquée sur le substrat (3) de manière épitaxiale.

## FIG 1a
Stand der Technik

## FIG 1b
Stand der Technik

## FIG 1c

## FIG 1d

FIG 2

FIG 3

FIG 4

## FIG 5

## FIG 6

## FIG 7

## FIG 8

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 19807758 A1
- WO 99931738 A
- US 5260588 A